# EUROPÄISCHE PATENTSCHRIFT

(11) **EP 1 773 618 B1**
(45) Veröffentlichungstag und Bekanntmachung des Hinweises auf die Patenterteilung: **30.01.2019**
(21) Anmeldenummer: 05767566.2
(22) Anmeldetag: 13.07.2005
(51) Int. Cl.: H01L 27/32, B60K 35/00

(54) **ANZEIGEVORRICHTUNG FÜR EIN KRAFTFAHRZEUG**
DISPLAY DEVICE FOR A MOTOR VEHICLE
DISPOSITIF D'AFFICHAGE POUR VEHICULE AUTOMOBILE

(30) Priorität: 22.07.2004 US 590136 P
(43) Veröffentlichungstag der Anmeldung: 18.04.2007
(73) Patentinhaber: Volkswagen Aktiengesellschaft, 38440 Wolfsburg (DE)
(72) Erfinder: DUPONT, Cedric, San Francisco, CA 94110 (US); ROSARIO, Daniel, Santa Cruz, CA 95060 (US); STOSCHEK, Arne, Palo Alto, CA 94303 (US)
(86) Internationale Anmeldenummer: PCT/EP2005/007574
(87) Internationale Veröffentlichungsnummer: WO 2006/010473

(56) Entgegenhaltungen:
- EP-A- 1 103 590
- FR-A- 2 839 578
- US-A1- 2001 033 135
- US-A1- 2003 099 025
- US-B1- 6 264 805
- US-B1- 6 281 788

## Beschreibung

Die Erfindung betrifft eine Anzeigevorrichtung für ein Kraftfahrzeug zur Anzeige einer das Kraftfahrzeug betreffenden Zahl oder eines das Kraftfahrzeug betreffenden Symbols.

Aus der DE 35 00 899 A1 ist ein Anzeigeinstrument mit quasi-kontinuierlicher, einem Zeigerinstrument ähnlicher Darstellung, insbesondere für Instrumentenfelder von Kraftfahrzeugen, zum Beispiel Tachometer-, Öldruck- oder Temperaturanzeige, mit einer Deckplatte und mehreren, nebeneinander in dieser Deckplatte angeordneten, einzeln ansteuerbaren Leuchtdioden bekannt, wobei eine Leiterplatte vorgesehen ist, in der die Leuchtdioden mittels Lötverbindungen gehalten sind, wobei die Deckplatte Passausnehmungen für die einzelnen Leuchtdioden aufweist, wobei benachbarte Passausnehmungen benachbarter Leuchtdioden durch vorzugsweise sehr schmale Querstege getrennt sind, wobei die Deckplatte aus einem undurchsichtigen Werkstoff, insbesondere Metall, gefertigt ist, und wobei die Deckplatte starr mit der Leiterplatte verbunden ist.

Aus der DE 43 19 441 A1 ist ein Elektrolumineszenz-Zifferblatt mit einem als Platte oder Folie ausgebildeten Trägerteil, mit einer Elektrolumineszenz-Komponente, die auf das Trägerteil aufgebracht ist, sowie mit einem Zifferblatt bekannt, wobei das Zifferblatt auf das mit der Elektrolumineszenz-Komponente versehene Trägerteil aufgedruckt ist. Auf das Trägerteil ist eine Metallschicht und auf diese die Elektrolumineszenz-Komponente in Art einer Phosphorschicht aufgedruckt. Zudem ist zwischen dem aufgedruckten Zifferblatt und der Phosphorschicht eine leitende Schicht aufgedruckt, wobei die Metallschicht und die leitende Schicht Elektrodenanschlüsse aufweisen.

Aus der WO 03/016086 ist eine Anzeigeeinheit, insbesondere für ein Kraftfahrzeug, bekannt, welche eine erste analoge Anzeige mit einem Zifferblatt und einem Zeiger und eine zweite digitale Anzeige aufweist, die bei einer entsprechende Ansteuerung für den Betrachter von demselben Blickpunkt aus wie das Zifferblatt sichtbar ist, wobei die zweite Anzeige durch ein transparentes Display vor der Ebene des Zifferblattes und parallel zu diesem auf der dem Betrachter zugewandten Seite angeordnet und für die Informationsdarstellung als selbstemittierendes Display ausgebildet ist. Die zweite Anzeige weist eine organisch Licht emittierende Substanz bzw. ein Polymer auf. Die zweite Anzeige ist vom Betrachter aus gesehen vor dem Zeiger angeordnet und bildet dadurch zugleich das Deckglas. Die zweite Anzeige besteht aus Kunststoffmaterial. Die Grafik des Zifferblattes ist transluzent, wobei hinter dem Zifferblatt eine ein flächiges, als organisch Licht emittierendes Bauteil ausgestaltete Durchlichtbeleuchtung angeordnet ist.

Die US 2003/0099025 A1 offenbart ein Head-Up-Display für ein Kraftfahrzeug mit einer Bilderzeugungseinheit 1, die eine OLED-Anzeige 8 aufweist.

Es ist Aufgabe der Erfindung, eine verbesserte Anzeigevorrichtung für ein Kraftfahrzeug zur Anzeige einer das Kraftfahrzeug betreffenden Zahl oder eines das Kraftfahrzeug betreffenden Symbols anzugeben.

### ZUSAMMENFASSUNG DER ERFINDUNG

Vorgenannte Aufgabe wird durch eine Anzeigevorrichtung für ein Kraftfahrzeug zur Anzeige einer das Kraftfahrzeug betreffenden Zahl (z.B. als Teil einer Analoganzeige oder einer Digitalanzeige) oder eines das Kraftfahrzeug betreffenden Symbols gelöst, wobei die Anzeigevorrichtung eine Schicht aus einem Licht emittierenden Polymer zum Emittieren von Licht einer ersten Farbe (z.B. weiß, blau, grün, gelb oder rot), eine transparente Trägerschicht und eine auf der transparenten Trägerschicht, insbesondere auf einer der Schicht aus dem Licht emittierenden Polymer abgewandten Seite der transparenten Trägerschicht, angeordnete Maske mit einer Öffnung in Form der Zahl oder des Symbols umfasst. Zwischen der transparenten Trägerschicht und der Schicht aus dem Licht emittierenden Polymer ist in einer Ausgestaltung der Erfindung eine transparente Elektrode, z.B. aus ITO (indium tin oxide), angeordnet.

In einer weiteren Ausgestaltung der Erfindung besteht die transparente Trägerschicht im wesentlichen aus flexiblem Material, insbesondere im wesentlichen aus flexiblem Kunststoff. Auf diese Weise lassen sich in besonders geeigneter Weise kostengünstig Anzeigevorrichtungen mit einer nicht planen Anzeigefläche herstellen.

In einer weiteren Ausgestaltung der Erfindung umfasst das Licht emittierende Polymer eine Spiroverbindung, z.B. eine Spiroverbindung gemäß der Formel 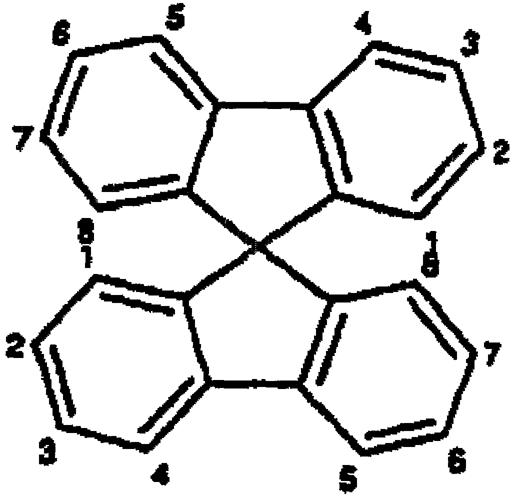 Einzelheiten derartiger Spiroverbindungen können der EP 0 676 461 B1 oder der US 5 840 217 entnommen werden. In einer alternativen Ausgestaltung der Erfindung umfasst das Licht emittierende Polymer Polyphenylenevinylene (PPV), z.B.
R-PPV, also 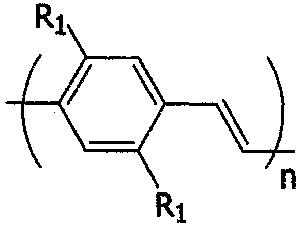 oder CN-PPV, also 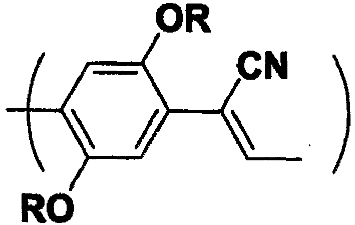 oder Polyfluorene. Verfahren zur Lösung von Polymeren zum anschließenden Drucken (z.B. auf den transparenten Träger bzw. eine auf dem transparenten Träger angeordnete Elektrode) können z.B. der WO 03/019694 A2 oder der DE 101 41 624 A1 entnommen werden.

In einer weiteren Ausgestaltung der Erfindung umfasst die Anzeigevorrichtung mindestens eine Schicht aus einem Licht emittierenden Polymer zum Emittieren von Licht mindestens einer zweiten (von der ersten Farbe verschiedenen) Farbe. In einer weiteren Ausgestaltung der Erfindung umfasst die Anzeigevorrichtung zudem eine Schicht aus einem Licht emittierenden Polymer zum Emittieren von Licht einer dritten (von der ersten Farbe und der zweiten Farbe verschiedenen) Farbe.
In einer weiteren Ausgestaltung der Erfindung ist die Schicht aus dem Licht emittierenden Polymer eine mittels eines Tintenstrahlverfahrens aufgebrachte Schicht.

In einer weiteren Ausgestaltung der Erfindung besteht die transparente Trägerschicht im wesentlichen aus flexiblem Material, insbesondere im wesentlichen aus flexiblem Kunststoff.
In einer weiteren Ausgestaltung der Erfindung umfasst das Licht emittierende Polymer eine Spiroverbindung. In einer alternativen Ausgestaltung der Erfindung umfasst das Licht emittierende Polymer Polyphenylenevinylene (PPV), z.B. R-PPV oder CN-PPV, oder Polyfluorene.
In einer weiteren Ausgestaltung der Erfindung umfasst die Anzeigevorrichtung eine Schicht aus einem Licht emittierenden Polymer zum Emittieren von Licht einer zweiten (von der ersten Farbe verschiedenen) Farbe. In einer weiteren Ausgestaltung der Erfindung umfasst die Anzeigevorrichtung zudem eine Schicht aus einem Licht emittierenden Polymer zum Emittieren von Licht einer dritten (von der ersten Farbe und der zweiten Farbe verschiedenen) Farbe.

In einer Ausgestaltung der Erfindung sind die erste Schicht aus dem ersten Licht emittierenden Polymer und die zweite Schicht aus dem zweiten Licht emittierenden Polymer je eine mittels eines Tintenstrahlverfahrens aufgebrachte Schichten.
In einer weiteren Ausgestaltung der Erfindung sind die erste Schicht aus dem ersten Licht emittierenden Polymer und die zweite Schicht aus dem zweiten Licht emittierenden Polymer auf einer gemeinsamen transparenten Trägerschicht angeordnet. In einer weiteren Ausgestaltung der Erfindung ist zwischen der transparenten Trägerschicht und der ersten Schicht aus dem ersten Licht emittierenden Polymer sowie zwischen der transparenten Trägerschicht und der zweiten Schicht aus dem zweiten Licht emittierenden Polymer eine transparente Elektrode angeordnet.
In einer weiteren Ausgestaltung der Erfindung ist auf einer der ersten Schicht aus dem ersten Licht emittierenden Polymer und der zweiten Schicht aus dem zweiten Licht emittierenden Polymer abgewandten Seite der transparenten Trägerschicht eine Maske mit einer Öffnung in Form der Zahl oder des Symbols angeordnet.
In einer weiteren Ausgestaltung der Erfindung besteht die transparente Trägerschicht im wesentlichen aus flexiblem Material, insbesondere im wesentlichen aus flexiblem Kunststoff.

In einer weiteren Ausgestaltung der Erfindung umfasst das erste oder das zweite Licht emittierende Polymer eine Spiroverbindung, z.B. eine Spiroverbindung gemäß der Formel

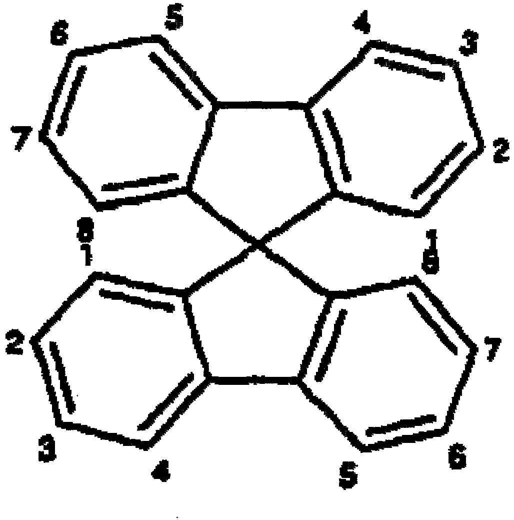

In einer alternativen Ausgestaltung der Erfindung umfasst das erste oder das zweite Licht emittierende Polymer Polyphenylenevinylene (PPV), z.B. R-PPV oder CN-PPV,oder Polyfluorene.

In einer weiteren Ausgestaltung der Erfindung umfasst das erste und das zweite Licht emittierende Polymer eine Spiroverbindung, z.B. eine Spiroverbindung gemäß der Formel

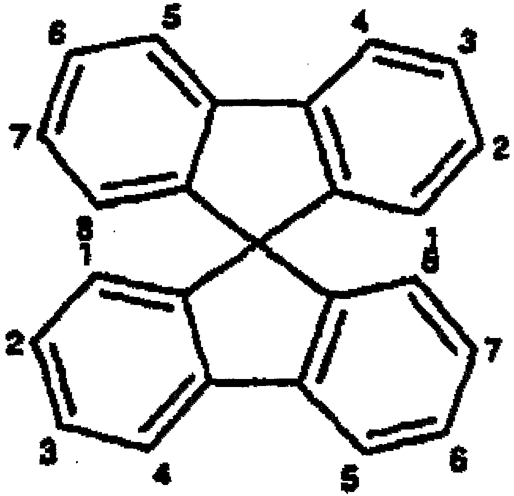

In einer alternativen Ausgestaltung der Erfindung umfasst das erste und das zweite Licht emittierende Polymer Polyphenylenevinylene (PPV), z.B. R-PPV oder CN-PPV, oder Polyfluorene.

In einer Ausgestaltung der Erfindung sind die erste Schicht aus dem ersten Licht emittierenden, die zweite Schicht aus dem zweiten Licht emittierenden Polymer und die dritte Schicht aus dem dritten Licht emittierenden Polymer je eine mittels eines Tintenstrahlverfahrens aufgebrachte Schichten.
In einer weiteren Ausgestaltung der Erfindung sind die erste Schicht aus dem ersten Licht emittierenden Polymer und die zweite Schicht aus dem zweiten Licht emittierenden Polymer, die zweite Schicht aus dem zweiten Licht emittierenden Polymer und die dritte Schicht aus dem dritten Licht emittierenden Polymer auf einer gemeinsamen transparenten Trägerschicht angeordnet. In einer weiteren Ausgestaltung der Erfindung ist zwischen der transparenten Trägerschicht und der ersten Schicht aus dem ersten Licht emittierenden Polymer, zwischen der transparenten Trägerschicht und der zweiten Schicht aus dem zweiten Licht emittierenden Polymer sowie zwischen der transparenten Trägerschicht und der dritten Schicht aus dem dritten Licht emittierenden Polymer eine transparente Elektrode angeordnet.
In einer weiteren Ausgestaltung der Erfindung ist auf einer der ersten Schicht aus dem ersten Licht emittierenden Polymer, der zweiten Schicht aus dem zweiten Licht emittierenden Polymer und der dritten Schicht aus dem dritten Licht emittierenden Polymer abgewandten Seite der transparenten Trägerschicht eine Maske mit einer Öffnung in Form der Zahl oder des Symbols angeordnet.

In einer weiteren Ausgestaltung der Erfindung besteht die transparente Trägerschicht im wesentlichen aus flexiblem Material, insbesondere im wesentlichen aus flexiblem Kunststoff.

In einer weiteren Ausgestaltung der Erfindung umfasst das erste, das zweite und/oder das dritte Licht emittierende Polymer eine Spiroverbindung, z.B. eine Spiroverbindung gemäß der Formel

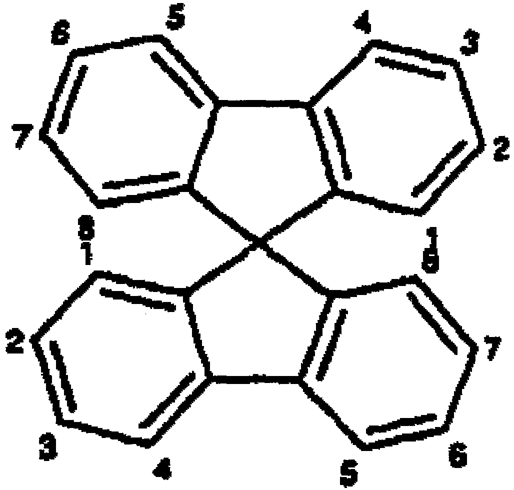

In einer alternativen Ausgestaltung der Erfindung umfasst das erste, das zweite und/oder das dritte Licht emittierende Polymer Polyphenylenevinylene (PPV), z.B. R-PPV oder CN-PPV,oder Polyfluorene.

Kraftfahrzeug im Sinne der Erfindung ist insbesondere ein individuell im Straßenverkehr benutzbares Landfahrzeug. Kraftfahrzeuge im Sinne der Erfindung sind insbesondere nicht auf Landfahrzeuge mit Verbrennungsmotor beschränkt. Unter Symbol im Sinne der Anmeldung werden alle Darstellungen, also auch Zahlen, Buchstaben, Buchstabenkombinationen, Bilder, Piktogramme usw..

### KURZE BESCHREIBUNG DER ZEICHNUNGEN

Fig. 1 zeigt ein Ausführungsbeispiel einer Anzeigevorrichtung für ein Kraftfahrzeug zur Anzeige einer das Kraftfahrzeug betreffenden Zahl oder eines das Kraftfahrzeug betreffenden Symbols;
Fig. 2 zeigt einen Ausschnitt eines Querschnitts der Anzeigevorrichtung gemäß Fig. 1; und
Fig. 3 zeigt die Anzeigevorrichtung gemäß Fig. 1 in einer rückwärtigen Ansicht.

### DETAILLIERTE BESCHREIBUNG VON BEVORZUGTEN AUSFÜHRUNGSBEISPIELEN

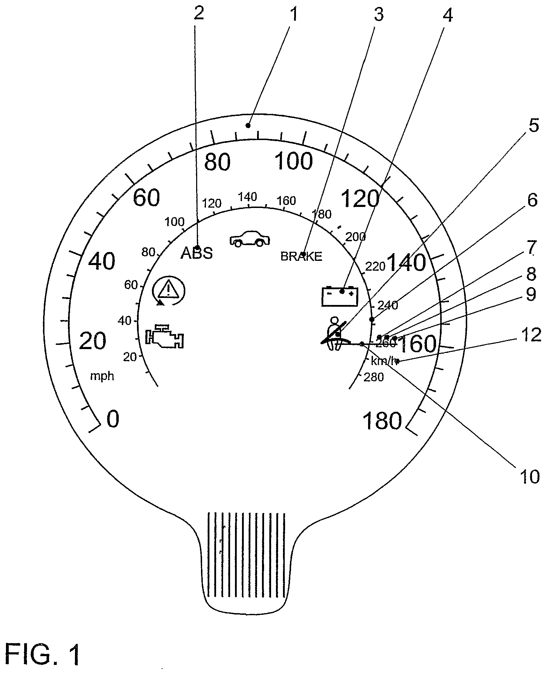

Fig. 1 zeigt eine Anzeigevorrichtung 1 für ein Kraftfahrzeug zur Anzeige einer das Kraftfahrzeug betreffenden Zahl oder eines das Kraftfahrzeug betreffenden Symbols. Eine das Kraftfahrzeug betreffende Zahl im Sinne der Erfindung kann z.B. - wie in Fig. 1 abgebildet - eine mit Bezugszeichen 7, 8, 9 bezeichnete Zahl einer Analoganzeige sein. Ein das Kraftfahrzeug betreffendes Symbol im Sinne der Erfindung kann z.B. - wie in Fig. 1 abgebildet - eine Linie 6 für eine Analoganzeige, eine Einheitenangabe 12 (z.B. km/h), ein Warnsignal 2 für eine Störung eines ABS (Anti-Blockier-System), ein Warnsignal 3 für eine angezogene Handbremse, ein Warnsignal 4 für einen Defekt einer Lichtmaschine oder ein Warnsignal 5 für einen nicht angelegten Sicherheitsgurt sein. In einem möglichen Ausführungsbeispiel können z.B. die Zahlen 7, 8, 9, die Einheitenangabe 12 und die Linie 6 blau leuchten. Das Warnsignal 3 für die angezogene Handbremse, das Warnsignal 4 für einen Defekt der Lichtmaschine und das Warnsignal 5 für einen nicht angelegten Sicherheitsgurt können z.B. rot leuchten. Das Warnsignal 2 für eine Störung des ABS kann z.B. gelb leuchten. Es kann z.B. auch vorgesehen sein, dass das Warnsignal 2 für eine Störung des ABS, das Warnsignal 3 für die angezogene Handbremse, das Warnsignal 4 für einen Defekt der Lichtmaschine, das Warnsignal 5 für einen nicht angelegten Sicherheitsgurt, die Zahlen 7, 8, 9, die Einheitenangabe 12 und die Linie 6 weiß leuchten.

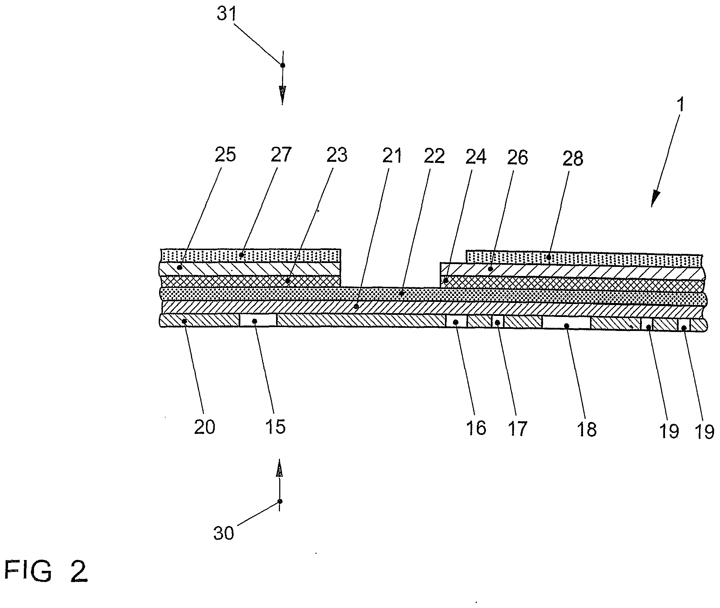

Fig. 2 zeigt einen durch einen in Fig. 1 mit Bezugszeichen 10 bezeichneten Strich markierten Ausschnitt eines Querschnitts der Anzeigevorrichtung 1 gemäß Fig. 1, wobei ein in Fig. 2 mit Bezugszeichen 30 bezeichneter Pfeil die Betrachtungsrichtung in Fig. 1 angibt. Die Anzeigevorrichtung 1 umfasst eine Maske 20 mit Öffnungen 15, 16, 17, 18, 19 in Form der darzustellenden Zahl oder des darzustellenden Symbols. So bezeichnet Bezugszeichen 15 eine Öffnung für das Warnsignal 5. Bezugszeichen 16 bezeichnet eine Öffnung für die Linie 6. Bezugszeichen 17 bezeichnet eine Öffnung für die mit Bezugszeichen 7 bezeichnete Zahl ,2', Bezugszeichen 18 bezeichnet eine Öffnung für die mit Bezugszeichen 8 bezeichnete Zahl ,6', und Bezugszeichen 19 bezeichnet eine Öffnung für die mit Bezugszeichen 9 bezeichnete Zahl ,0'.

In Bezug auf die Betrachtungsrichtung unterhalb der Maske 20 ist eine im wesentlichen aus flexiblem Material, insbesondere im wesentlichen aus flexiblem Kunststoff, bestehende transparente Trägerschicht 21 angeordnet. In Bezug auf die Betrachtungsrichtung unterhalb der transparenten Trägerschicht 21 ist eine transparente Elektrode 22, z.B. aus ITO, angeordnet. In Bezug auf die Betrachtungsrichtung unterhalb der transparenten Elektrode 22 ist eine leitende Polymerschicht 23 bzw. 24 z.B. aus PANI, PDOT oder PSS angeordnet. In Bezug auf die Betrachtungsrichtung unterhalb der leitenden Polymerschichten 23 bzw. 24 und oberhalb von Rückelektroden 27 und 28 sind Schichten 25 bzw. 26 aus einem Licht emittierenden Polymer angeordnet.
Als derartiges Licht emittierendes Polymer können z.B. Spiroverbindungen, wie z.B. eine Spiroverbindung gemäß der Formel 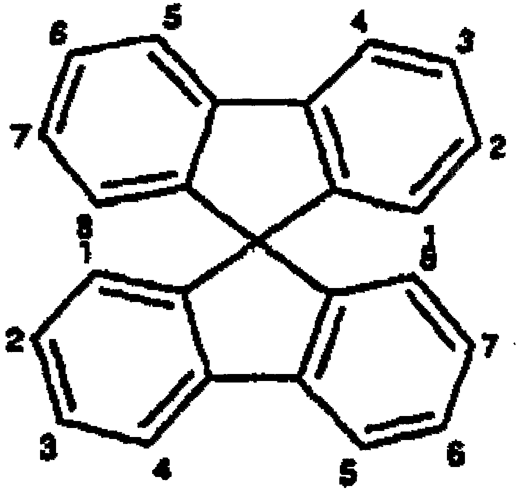 verwendet werden. Einzelheiten derartiger Spiroverbindungen können der EP 0 676 461 B1 oder der US 5 840 217 entnommen werden. Weitere Einzelheiten zu Spiroverbindungen können der Internetseite www.covion.com/technology/tech_summary.html entnommen werden. Es kann z.B. vorgesehen sein, dass das Licht emittierende Polymer der Schicht 25 Covion PolySpiroRed CR01 und das Licht emittierende Polymer der Schicht 26 Covion PolySpiroBlue CB02 ist.
In einer alternativen Ausgestaltung umfasst das Licht emittierende Polymer der Schicht 25 oder 26 Polyphenylenevinylene (PPV), z.B.
R-PPV, also 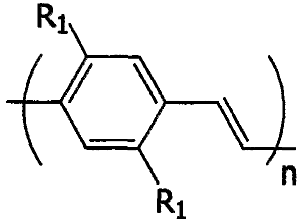 oder CN-PPV, also 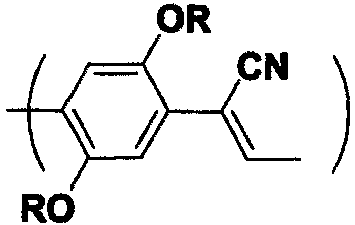 oder Polyfluorene. Verfahren zur Lösung von Polymeren zum anschließenden Drucken können z.B. der WO 03/019694 A2 oder der DE 101 41 624 A1 sowie der oben genannten Internetseite www.covion.com/technology/tech_summary.html entnommen werden.
Es kann z.B. auch vorgesehen sein, dass das Licht emittierende Polymer der Schicht 25 CN-PPV und das Licht emittierende Polymer der Schicht 26 Covion PolySpiroBlue CB02 ist.
Der in Fig. 2 dargestellte Aufbau ist lediglich beispielhaft. Es kann auch eine andere Anordnung der Schichten vorgesehen sein, wie sie z.B. in der US 6 605 483 offenbart ist.

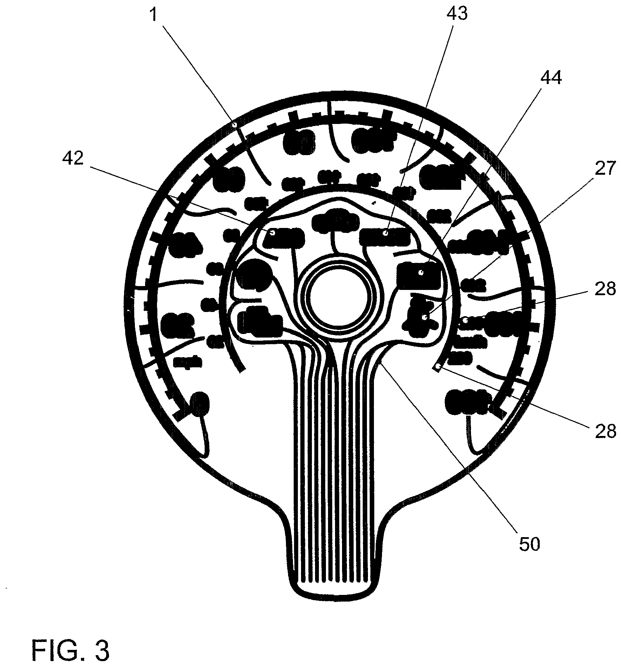

Fig. 3 zeigt die Anzeigevorrichtung 1 gemäß Fig. 1 in einer rückwärtigen Ansicht, wobei ein in Fig. 2 mit Bezugszeichen 31 bezeichneter Pfeil die Betrachtungsrichtung in Fig. 3 angibt. Dabei bezeichnen Bezugszeichen 42, 43 und 44 Rückelektroden für die Darstellungen der Warnsignale 2, 3 und 4. Mit Bezugszeichen 50 ist ein elektrischer Leiter bezeichnet.
Die Erfindung erlaubt die Herstellung besonders kostengünstiger und gleichzeitig besonders gut ablesbarer Anzeigevorrichtungen für Kraftfahrzeuge. Insbesondere die gute und schnelle Ablesbarkeit ist eine für Anzeigevorrichtungen für Kraftfahrzeuge besonders wichtige Eigenschaft. Diese wichtige Eigenschaft wird mittels der Erfindung in besonders kostengünstiger Weise erzielt.

Die erfinderische Anzeigevorrichtung sind auch besonders geeignet für die Anzeige einer PDC (Park Distance Control) geeignet. Dabei können insbesondere verschieden farbige Leuchtstreifen den Abstand zu einem Hindernis angeben.

Die Schichten in den Figuren sind unter Berücksichtigung von Einfachheit und Klarheit und nicht notwendigerweise maßstabsgetreu gezeichnet. So sind z.B. die Größenordnungen einiger Schichten übertrieben gegenüber anderen Schichten dargestellt, um das Verständnis der Ausführungsbeispiele der vorliegenden Erfindung zu verbessern.

### Bezugszeichenliste

- 1: Anzeigevorrichtung
- 2, 3, 4, 5: Warnsignal
- 6: Linie
- 7, 8, 9: Zahl
- 10: Strich
- 12: Einheitenangabe
- 20: Maske
- 15, 16, 17, 18, 19: Öffnung
- 21: Trägerschicht
- 22: transparente Elektrode
- 23, 24: leitende Polymerschicht
- 25, 26: Schichten aus einem Licht emittierenden Polymer
- 27, 28, 42, 43, 44: Rückelektroden
- 30, 31: Pfeil
- 50: elektrischer Leiter

## Patentansprüche

1. Anzeigevorrichtung (1) für ein Kraftfahrzeug zur Anzeige einer das Kraftfahrzeug betreffenden Zahl (7, 8, 9) oder eines das Kraftfahrzeug betreffenden Symbols (2, 3, 4, 5, 6, 12), die Anzeigevorrichtung (1) umfassend:
eine Schicht (25, 26) aus einem Licht emittierenden Polymer zum Emittieren von Licht einer ersten Farbe;
eine transparente Trägerschicht (21); **gekennzeichnet durch** eine auf der transparenten Trägerschicht (21) angeordnete Maske (20) mit einer Öffnung in Form der Zahl (7, 8, 9) oder des Symbols (2, 3, 4, 5, 6, 12).

2. Anzeigevorrichtung (1) nach Anspruch 1, wobei die Schicht (25, 26) aus dem Licht emittierenden Polymer auf einer der Maske (20) abgewandten Seite der transparenten Schicht (25, 26) angeordnet ist.

3. Anzeigevorrichtung (1) nach Anspruch 1 oder 2, wobei die transparente Trägerschicht (21) im wesentlichen aus flexiblem Material besteht.

4. Anzeigevorrichtung (1) nach Anspruch 1, 2 oder 3, das Licht emittierende Polymer umfassend: eine Spiroverbindung.

5. Anzeigevorrichtung (1) nach Anspruch 1, 2, 3 oder 4, weiterhin umfassend:
mindestens eine Schicht (25, 26) aus einem Licht emittierenden Polymer zum Emittieren von Licht mindestens einer zweiten Farbe.

6. Anzeigevorrichtung (1) nach Anspruch 5, wobei die Anzeigevorrichtung (1) zudem eine Schicht (25, 26) aus einem Licht emittierenden Polymer zum Emittieren von Licht einer dritten von der ersten Farbe und der zweiten Farbe verschiedenen Farbe umfasst.

7. Anzeigevorrichtung (1) nach einem der vorhergehenden Ansprüche, wobei die Zahl (7, 8, 9) Teil einer Anzeigevorrichtung (1) ist.

8. Anzeigevorrichtung (1) nach einem der vorhergehenden Ansprüche, wobei zwischen der transparenten Trägerschicht (21) und der Schicht (25, 26) aus dem Licht emittierenden Polymer eine transparente Elektrode (22) angeordnet ist.

9. Anzeigevorrichtung (1) nach Anspruch 8, wobei die transparente Elektrode (22) ITO (indium tin oxide) umfasst.

## Claims

1. Display device (1) for a motor vehicle for displaying a number (7, 8, 9) relating to the motor vehicle or a symbol (2, 3, 4, 5, 6, 12) relating to the motor vehicle, the display device (1) comprising: a layer (25, 26) made of a light-emitting polymer for emitting light of a first colour; a transparent carrier layer (21); **characterized by** a mask (20), which is arranged on the transparent carrier layer (21) and has an opening in the form of the number (7, 8, 9) or of the symbol (2, 3, 4, 5, 6, 12).

2. Display device (1) according to Claim 1, wherein the layer (25, 26) made of the light-emitting polymer is arranged on a side of the transparent layer (25, 26) which is remote from the mask (20).

3. Display device (1) according to Claim 1 or 2, wherein the transparent carrier layer (21) consists essentially of flexible material.

4. Display device (1) according to Claim 1, 2 or 3, the light-emitting polymer comprising: a spiro compound.

5. Display device (1) according to Claim 1, 2, 3 or 4, further comprising: at least one layer (25, 26) made of a light-emitting polymer for emitting light at least of a second colour.

6. Display device (1) according to Claim 5, wherein the display device (1) moreover comprises a layer (25, 26) made of a light-emitting polymer for emitting light of a third colour which differs from the first colour and the second colour.

7. Display device (1) according to one of the preceding claims, wherein the number (7, 8, 9) is part of a display device (1).

8. Display device (1) according to one of the preceding claims, wherein a transparent electrode (22) is arranged between the transparent carrier layer (21) and the layer (25, 26) made of the light-emitting polymer.

9. Display device (1) according to Claim 8, wherein the transparent electrode (22) comprises ITO (indium tin oxide).

## Revendications

1. Dispositif d'affichage (1) pour un véhicule automobile, servant à afficher un chiffre (7, 8, 9) concernant le véhicule automobile ou un symbole (2, 3, 4, 5, 6, 12) concernant le véhicule automobile, le dispositif d'affichage (1) comprenant :
une couche (25, 26) constituée par un polymère émettant de la lumière, destiné à émettre de la lumière d'une première couleur ;
une couche support transparente (21) ; **caractérisé par** un masque (20) qui est agencé sur la couche support transparente (21) et qui comporte une ouverture ayant la forme du chiffre (7, 8, 9) ou du symbole (2, 3, 4, 5, 6, 12) .

2. Dispositif d'affichage (1) selon la revendication 1, dans lequel la couche (25, 26) constituée par le polymère émettant de la lumière est agencée sur un côté opposé au masque (20) de la couche transparente (25, 26).

3. Dispositif d'affichage (1) selon la revendication 1 ou 2, dans lequel la couche support transparente (21) est essentiellement constituée par un matériau flexible.

4. Dispositif d'affichage (1) selon la revendication 1, 2 ou 3, dans lequel le polymère émettant de la lumière comprend un composé spiro.

5. Dispositif d'affichage (1) selon la revendication 1, 2, 3 ou 4, comprenant en outre :
au moins une couche (25, 26) constituée par un polymère émettant de la lumière, destiné à émettre de la lumière d'au moins une deuxième couleur.

6. Dispositif d'affichage (1) selon la revendication 5, dans lequel le dispositif d'affichage (1) comprend en outre une couche (25, 26) constituée par un polymère émettant de la lumière, destiné à émettre de la lumière d'une troisième couleur différente de la première couleur et de la deuxième couleur.

7. Dispositif d'affichage (1) selon l'une quelconque des revendications précédentes, dans lequel le chiffre (7, 8, 9) fait partie d'un dispositif d'affichage (1).

8. Dispositif d'affichage (1) selon l'une quelconque des revendications précédentes, dans lequel une électrode transparente (22) est agencée entre la couche support transparente (21) et la couche (25, 26) constituée par le polymère émettant de la lumière.

9. Dispositif d'affichage (1) selon la revendication 8, dans lequel l'électrode transparente (22) comprend de l'ITO (oxyde d'indium et d'étain).
